Europäisches Patentamt

European Patent Office

Office européen des brevets

(19)

(11) Publication number: **0 231 916 B1**

# EUROPEAN PATENT SPECIFICATION

(12)

(45) Date of publication of patent specification: **30.12.92**  (51) Int. Cl.5: **G03F  1/00**

(21) Application number: **87101361.1**

(22) Date of filing: **02.02.87**

(54) **X-ray exposure masks.**

(30) Priority: **03.02.86 JP 22562/86**

(43) Date of publication of application:
**12.08.87 Bulletin  87/33**

(45) Publication of the grant of the patent:
**30.12.92 Bulletin  92/53**

(84) Designated Contracting States:
**DE FR GB**

(56) References cited:

**Patent Abstracts of Japan, vol. 9, no. 291
(E-359)(2014) 19 November 1985, & JP-A-60
132323**

**Patent Abstracts of Japan, vol. 7, no. 40
(E-159)(1185) 17 February 1983, & JP-A-57
193031**

(73) Proprietor: **FUJITSU LIMITED
1015, Kamikodanaka Nakahara-ku
Kawasaki-shi Kanagawa 211(JP)**

(72) Inventor: **Nakagawa, Kenji Fujitsu Ltd.Pat.Dep.
Kosugi Fujitsu Bld. 1812-10 Shimonumabe
Nakahara-ku Kawasaki-shi Kanagawa 211(JP)**

(74) Representative: **Sunderland, James Harry et al
HASELTINE LAKE & CO Hazlitt House 28
Southampton Buildings Chancery Lane
London WC2A 1AT(GB)**

Rank Xerox (UK) Business Services

# Description

The present invention relates to X-ray exposure masks, for example for use in forming microscopic patterns for high density semiconductor devices.

With the recent trend towards high packing density in semiconductor devices, micropatterning is the usual means of fabricating high density semiconductor devices. An effort is now being made to develop X-ray exposure technology.

With X-ray exposure technology a microscopic pattern is formed on a semiconductor wafer by exposing an X-ray resist coated on the semiconductor wafer to an X-ray beam having a wavelength of several angstroms.

When a light beam or an electron beam is used for patterning a microscopic pattern having features of submicron order, diffraction, interference, and scattering of the light beam or the electron beam produce a problem in that the resolution of the microscopic pattern is reduced. This problem can be avoided by using X-ray exposure technology.

Because the wavelength of an X-ray beam is very short, a conventional light exposure mask cannot be used in X-ray exposure technology; an X-ray exposure mask having a special structure suitable for use with the X-ray beam is employed. Hereafter, an X-ray exposure mask will be called "an X-ray mask", for brevity. Whilst a special mask is used for patterning a microscopic pattern with the employment of an X-ray beam, the patterning is still carried out in much the same way as for ordinary semiconductor devices. That is, many similar patterns, for fabricating a plurality of semiconductor chips, are formed on a semiconductor wafer using a pattern apparatus called "stepper", and furthermore a plurality of different patterns are stacked or overlayed by repeating the patterning process.

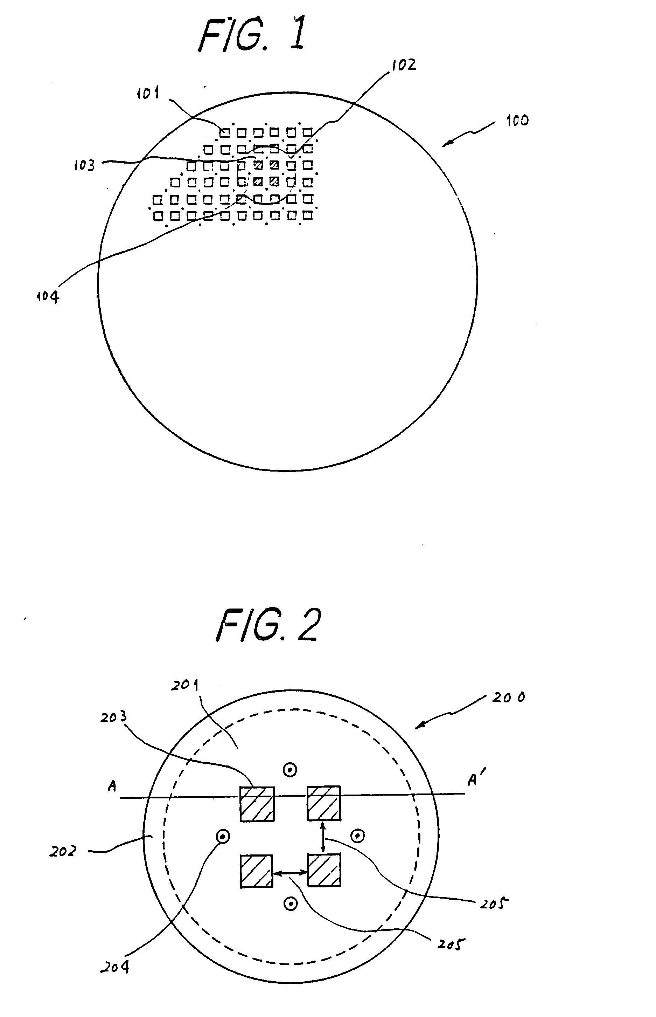

Fig. 1 is a schematic diagram of a plurality of chip patterns 101 formed on a semiconductor wafer 100. In order to stack or overlay a plurality of patterns having different shapes or configurations respectively, a plurality of X-ray masks respectively having different patterns are necessary.

Fig. 2 is a schematic diagram of an example of such X-ray mask. 200 indicates the X-ray mask and 201 is a membrane supported by a ring frame 202 (which will be called, simply, a "ring" hereinafter). The nature of the membrane 201 will be explained in more detail below. 203 is a pattern for a semiconductor chip formed on the membrane 201. In the example of Fig. 2, four patterns 203 are provided of the same shape and size. An X-ray pattern obtained from the patterns 203 by using an X-ray beam are sequentially exposed on a semiconductor wafer as shown in Fig. 1; hatched patterns 103 within circle 102 in Fig. 1 indicate patterns being exposed sequentially. A pattern 203 in Fig. 2 is a pattern used for forming a chip pattern. Several patterns, different from the pattern 203, are usually stacked or overlayed in order to complete a semiconductor chip pattern. That is, semiconductor chip patterns are formed on the semiconductor wafer by using other masks, each having the same structure as that of mask 200 but having different (mask) patterns, for completing the semiconductor chip patterns by stacking or overlaying the X-ray patterns of the different (mask) patterns at the same position respectively.

Particularly, stacking or overlaying of patterns must be carried out accurately, because each pattern to be stacked is a microscopic pattern. In other words, positioning of the X-ray masks is very important.

Currently it is believed the use of a light beam for positioning the X-ray masks offers the best results. Four mask positioning marks 204, for such X-ray mask positioning, are depicted in Fig. 2. Dots 104 depicted in Fig. 1 are wafer positioning marks previously provided on the semiconductor wafer 100.

Sequential exposures of X-ray patterns, using different X-ray masks, onto the semiconductor wafer 100 are executed by sequentially aligning mask positioning marks on the X-ray masks to wafer positioning marks on the semiconductor wafer 100 using a light beam.

For executing positioning using a light beam, an optical mask alignment technology utilizing diffraction of the light beam is presently evaluated as the most advanced technology from the point of view of accuracy. This optical mask alignment technology has been explained in detail in "Application of zone plates to alignment in microlithography" by M. Feldman et al (J. Vac. Sci. Technol., Vol. 19, Vo. 4, Nov./Dec. 1981). As explained in this document, an X-ray mask must have the structure of a window, through which a light beam can pass, around each mask positioning mark, in order that optical mask alignment technology can be applied. A part of an incident light beam is reflected by a mask positioning mark on the X-ray mask but the rest of the incident light beam reaches a wafer positioning mark, previously marked on the semiconductor wafer, passing through the window provided at the periphery of the mask positioning mark, and is reflected by the wafer positioning mark. The light beam reflected by the wafer positioning mark again passes through the window and is gathered in a light condensing system with the light beam reflected by the mask positioning mark. The mask positioning mark and the wafer positioning mark are imaged in the light condensing system and compared with each other.

Then the position of the X-ray mask is adjusted relative to that of the semiconductor wafer until the images are superimposed on each other. Thus the positions of the X-ray mask and the semiconductor wafer are aligned.

Thus, a light beam is used for mask alignment in a patterning process although an X-ray beam is used for patterning in the fabrication of a high density semiconductor device. The material of the X-ray mask itself should be translucent not only to the X-ray beam but also to the light beam because it is difficult to make only a window portion of the X-ray mask translucent to the light beam, from the point of view of cost, which is a significant consideration in relation to the present invention.

As a substrate for an X-ray mask, a membrane composed of a material having a good transmission characteristic for the X-ray beam, such as boron nitride (BN), having a small atomic number, is used.

In the case of a conventional substrate such as glass or quartz (used for light beam masks) X-rays cannot be used because such substrates have low transmission factors for X-rays.

This BN membrane is also translucent to the light beam because it has a thickness of as little as several microns. However, the membrane has low mechanical strength and cannot be maintained by itself, in a flat condition, and therefore the membrane is adhered to a ring frame to be supported.

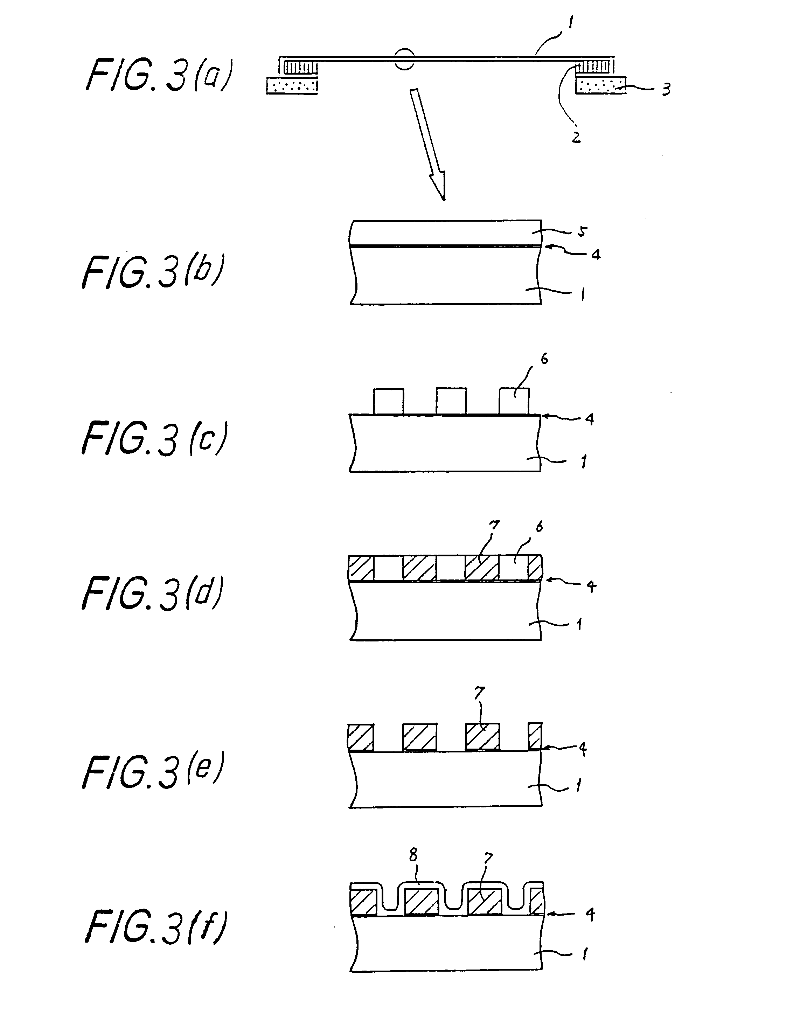

Figs. 3(a) to 3(f) are schematic diagrams which indicate a previously proposed process for fabricating an X-ray mask. These Figures may be understood, as an example, as diagrams corresponding to a sectional view along line A-A′ in Fig. 2 and with the wide space between the two patterns 203 related to the line A-A′ eliminated. The previous X-ray mask has been fabricated by the following process.

(1) A BN membrane is deposited by chemical vapour deposition (CVD) on a silicon wafer (Si wafer) which is adhered to a ring frame (a "ring"), made of material, such as PYREX or ceramics, having a small thermal expansion coefficient.

(2) From one side, on which the BN membrane is not deposited, an internal part of the Si wafer (from the point of view of the ring) is removed by etchant (leaving a silicon rim or ring 2). Thereby, the BN membrane 1 is supported in a flat condition by a ring 3 as shown in Fig.3(a).

(3) Titanium, tantalum - gold - tantalum, gold, or platinum, etc., is sputtered, to a thickness of about 400 - 500 Angstroms, on the BN membrane 1. The $puttered layer forms a plating base 4 which is a base layer for easy plating of metal on the BN membrane 1.

(4) A photo resist consisting of a polymeric resin, or an electron beam (EB) resist, 5 is coated on the plating base 4 as shown in Fig. 3-(b).

(5) The photo resist or the EB resist 5 is exposed or written by a light beam or an electron beam and then developed and thereby a photo resist pattern or an EB resist pattern called a stencil 6 is formed as shown in Fig. 3(c)

(6) Metal of gold (Au) is plated on the plating base 4 using the plating base 4 as an electrode, and apertures in the stencil 6 are filled up by an Au layer 7 as shown in Fig. 3(d). The Au layer 7 is an X-ray beam absorber.

(7) After the apertures in the stencil 6 have been filled up by the Au layer 7, the stencil 6 is removed by an ashing process.

(8) The plating base 4 appearing (exposed) after the stencil 6 is removed is then removed by reactive ion etching (RIE) using carbon tetrafluoride ($CF_4$) gas, or by sputter etching using argon (Ar) gas. Fig. 3(e) indicates a state where the stencil 6 and plating base 4 thereunder have been eliminated. The stencil 6 and plating base 4 thereunder are eliminated in order that the X-ray mask 200 is light beam translucent in the vicinity of the positioning marks 204, for executing mask alignment.

(9) Finally, as shown in Fig. 3(f), whole faces of the Au layer 7 and the membrane 1 are coated with a thin protection layer 8 which is translucent to the X-ray beam and the light beam, and thus the X-ray mask is completed.

This previous X-ray mask requires elimination of the stencil 6 and plating base 4 thereunder, which gives rise to a problem in that grooves formed between the Au layers 7 after elimination of the stencil 6 and plating base 4 are very (too) narrow. The grooves are easily destroyed or damaged in subsequent processing, so that some parts of the patterns provided by the grooves are deformed or eliminated, and some of the Au layers 7 can be peeled off In more detail, an Au layer 7 is required to have height of 0.5 to 1 micron in order to absorb X-rays, and the width of a stencil (groove) 6 is 1 micron or less, for example 0.1 to 0.2 micron in some cases, so that patterns of the Au layer 7 have a high aspect ratio, resulting in the fabricating structure being easily damaged.

With a view to solving this problem of fragility, an X-ray mask has been developed by WADA, wherein a material having a high X-ray transmission factor is used for the stencil, the plating base is sufficiently thin to allow X-rays to pass therethrough and the stencil is not required to be eliminated (Japan Published Unexamined Patent Application No. 193031 (1982)). According to WADA, polycrystalline silicon, silicon nitride, silicon oxide or a composite of those materials is used for the stencil. Although such a stencil will transmit an X-ray beam, transmission factor for a light beam is not considered. Accordingly, translucency for a light beam in the vicinity of positioning marks cannot be provided for this X-ray mask.

The provision of mask positioning marks in areas far from the patterns for the chips, such as an area near the ring, must generally be avoided. Positional errors due to thermal expansion effects manifest between positioning marks and chip patterns increase. Spacings 205 (Fig. 2) and positions for mask positioning marks 204 in Fig. 2 are determined with this in mind. However, since it is difficult, particularly in terms of cost, to provide light beam translucency only in the vicinity of each mask positioning mark, the stencil 6 must be eliminated in the fabrication process of the X-ray mask.

Patent Abstracts of Japan, Vol. 9, No. 291 (E-359) (2014), 19th November 1985, and JP-A-60 132323, discloses an X-ray exposure mask with an X-ray absorber supporting member (1', 2, 3, 4) on which a visible-light transparent conductive material (5) is interposed between the supporting member and an absorption pattern (7). The visible-light transparent conductive material is an ITO film, and the absorber pattern is of gold.

According to the present invention, there is provided an X-ray exposure mask, comprising:-

a mask substrate translucent to X-ray and light beams;

an electrically conductive layer on the mask substrate, translucent to X-ray and light beams; and

X-ray absorption means;
characterised by

a stencil pattern structure formed on the electrically conductive layer, translucent to light;

a metal layer formed on the electrically conductive layer, for forming a plating base with the electrically conductive layer, the metal layer being translucent to X-ray and light beams; and by

the X-ray absorption means being formed on the metal layer in the stencil apertures of the stencil pattern structure.

An embodiment of the present invention can provide an improved structure for an X-ray mask, can enhance fabrication yield of X-ray masks and reliability such that metal parts of an X-ray mask (which absorb X-rays) and microscopic patterns for chips (formed by narrow spaces between such metal parts) are not or are less easily deformed or destroyed during X-ray mask fabrication or during handling after fabrication.

An embodiment of the present invention can provide for enhanced quality of high density semiconductor devices and improved fabrication yield by allowing the X-ray mask to absorb not only the X-ray but also visible light beam and by realizing high precision positioning alignment using the visible light beam during use of the X-ray mask.

An embodiment of the present invention can afford lower X-ray mask fabrication costs, and can thus reduce cost of fabrication of high density semiconductor devices using X-ray masks, by simplifying X-ray mask fabrication.

In an embodiment of the present invention Indium Tin Oxide (ITO) is employed, onto which gold is sputtered for a plating base. The ITO is translucent to X-ray and light beams and is electrically conductive, and sputtered gold thereon has a thickness, generally between 1 and 67 Angstroms, such as to be translucent to the X-ray and light beams.

Reference is made, by way of example, to the accompanying drawings, in which:

Fig. 1 is a schematic diagram indicating a plurality of chip patterns and wafer positioning marks formed on a semiconductor wafer;

Fig. 2 is a schematic diagram of an X-ray mask depicting patterns on the mask and mask positioning marks;

Figs. 3(a) to 3(f) are schematic diagrams illustrating fabrication of a previously proposed X-ray mask; and

Figs. 4(a) to 4(h) are schematic partial crosssectional diagrams illustrating fabrication of an X-ray mask in accordance with an embodiment of the present invention; Fig. 4(h) illustrates the structure of a finished mask.

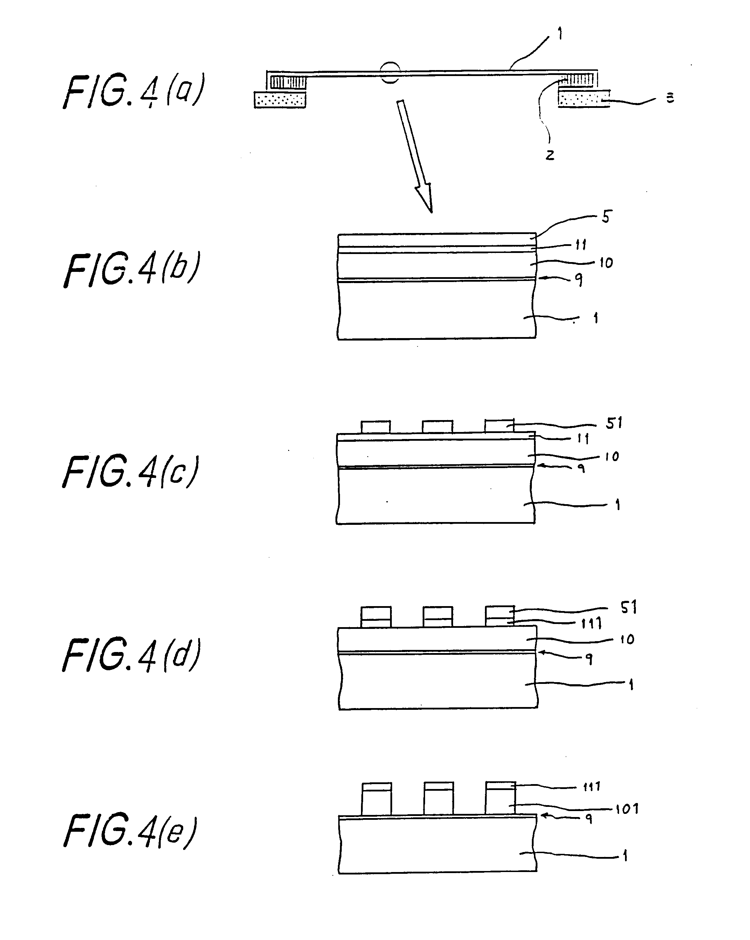

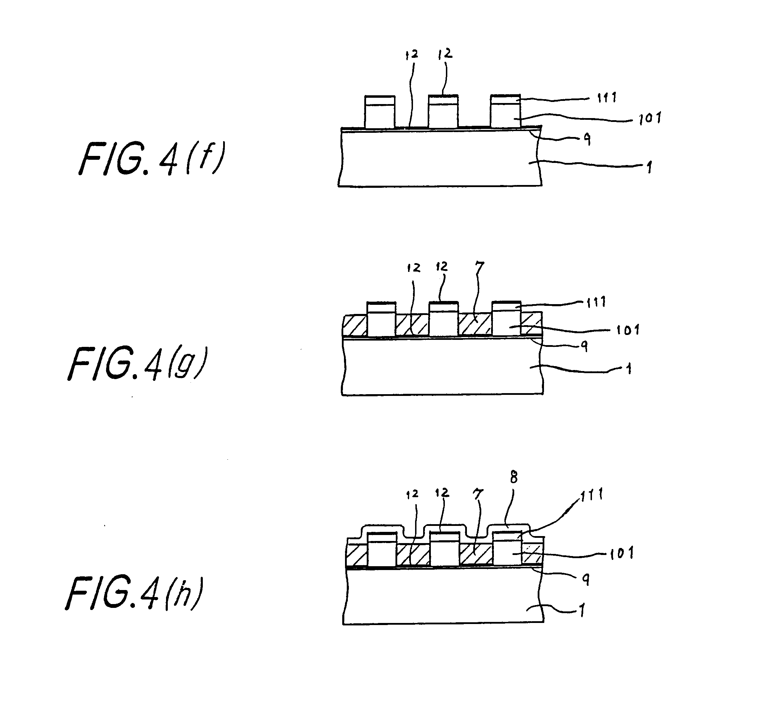

As shown in Fig. 4(h), the structure of an X-ray mask embodying the present invention comprises the following parts: a membrane 1, which is a mask substrate, made of material, such as boron nitride (BN), being X-ray and light beam translucent; an electrically conductive layer 9 sputtered on the membrane 1 and made of material, such as Indium Tin Oxide (ITO), being electrically conductive and X-ray and light beam translucent; a stencil structure, formed to a pattern for forming semiconductor chip patterns onto a semiconductor wafer, each part of the stencil comprising a (remaining) polymer part 101 which is coated on the electrically conductive layer 9 and is X-ray and light beam translucent; and an X-ray absorber 7, of gold, filling apertures in the pattern of the stencil.

Each part of the stencil further comprises a (remaining) inorganic part 111 which is made of inorganic material such as silicon dioxide, sputtered on the (remaining) polymer part 101, and a thin gold layer 12 sputtered on the (remaining) inorganic part 111. The (remaining) inorganic part 101 and the thin gold layer 12 are translucent to X-ray and light beams, so that the accurate mask alignment can be executed by using a light beam passing through the mask. The thin gold layer 12 is also sputtered on the electrically conductive layer 9; the purpose of the sputtering of the thin gold layer 12 being that of forming a plating base in combination with the electrically conductive layer 9, for the plating of the X-ray absorber 7. A thickness of the thin gold layer 12 is so delicate that the thickness should (preferably) be more than one Angstrom for executing the plating and less than sixty-seven Angstroms for passing a light beam therethrough to execute mask alignment.

A fabrication process for an X-ray mask according to an embodiment of the invention is as follows.

(1) Providing a membrane 1, of BN, being translucent to X-ray and light beams and supported by a ring 3 made of PYREX or ceramics through a silicon rim or ring 2, as shown in Fig. 4(a). This process is the same as that explained with reference to the previously proposed X-ray mask in Fig. 3(a).

(2) As shown in Fig. 4(b),

sputtering Indium Tin Oxide (ITO) onto the membrane 1 to a thickness between 300 and 3,000 Angstroms to form an electrically conductive layer 9. The ITO is made by mixing 5 to 20% of tin oxide ($SnO_2$) to indium oxide ($In_2O_3$). The ITO is not only electrically conductive but also translucent to X-ray and light beams;

sputtering Polymer such as polyimide onto the electrically conductive layer 9, to a thickness of 1 to 2 microns when polyimide is used, to form a polymer layer 10;

sputtering inorganic material such as silicon dioxide ($SiO_2$) on the polymer layer 10, to a thickness of 500 to 2000 Angstroms, for form an inorganic layer 11; and

spin-coating electron beam (EB) resist material on the inorganic layer 11, to a thickness of 1000 to 5000 Angstroms, to form an EB resist layer 5 (a photo resist can be used instead of the EB resist).

(3) Writing patterns for semiconductor chips on the EB resist 5, using an electron beam, and developing the resist, so that remaining EB resist parts 51 are left in place as shown in Fig. 4-(c).

(4) Etching the inorganic layer 11, by applying RIE using trifluoromethane ($CHF_3$) gas and the $CF_4$ gas when the inorganic layer 11 is made of silicon dioxide, so that a remaining inorganic part 111 is left under each remaining resist part 51 as shown in Fig. 4(d).

(5) Etching the polymer layer 10, by applying RIE using the dioxide (oxygen) ($O_2$) gas when the polymer layer 10 is made of polyimide, so that remaining polymer parts 101 are left in place. In this case, each remaining EB resist part 51 is also etched and the structure of Fig. 4(e) is obtained. In Fig. 4(e), the remaining polymer parts 101 and the remaining inorganic parts 111 form a stencil.

(6) Sputtering Au on the whole surface of the mask under fabrication, to a thickness between 1 and 67 Angstroms to obtain an Au thin layer 12 as shown in Fig. 4(f). When the thickness of the Au layer 12 is 67 Angstroms, the X-ray beam transmission factor is negligible, and the light beam (strictly, an He-He laser beam) transmission factor is 30%, which is approximately a limit value for executing mask alignment. However, 67 Angstroms is not a strict limit value, a little increase may be allowed. The Au layer 12 sputtered on the electrically conductive layer 9 other than the stencil part becomes a plating base for plating metal of Au in the next process.

(7) Plating metal of Au on the plating base using the plating base as an electrode to form an X-ray absorber 7, so that apertures in the stencil are (at least partially) filled up with the X-ray absorber 7.

(8) Finally, coating the whole faces of the stencil and the X-ray absorber with a protection membrane 8 as shown in Fig. 4(h), to complete the X-ray mask.

As mentioned above, by the application of an embodiment of the present invention to the fabrication of an X-ray mask, stencil removal processing is eliminated. Since the stencil is not removed, X-ray absorber 7 is not likely to be bent or damaged, and thereby reliability of the X-ray mask is improved. Moreover, since the stencil is translucent to both X-ray and light beams, high precision mask alignment can be realized by using the light beam.

An embodiment of the present invention provides an X-ray mask comprising an electrically conductive layer translucent to X-ray and light beams, a gold layer formed on the electrically conductive layer, of a thickness such as to be translucent to X-ray and light beams, for forming a plating base in combination with the electrically conductive layer, a stencil structure, translucent to X-ray and light beams, formed on the electrically conductive layer to a mask pattern for forming a microscopic pattern on a semiconductor wafer, and a gold X-ray absorber, plated on the plating base, in apertures in the stencil structure. Alignment of the X-ray mask to a semiconductor wafer can be precisely executed using a light beam passing through the stencil structure.

An embodiment of the present invention provides an X-ray exposure mask used for patterning a semiconductor wafer with semiconductor chip patterns by using an X-ray beam, a position of the mask relative to the wafer being aligned in a process of the patterning by using a light beam, said mask comprising:

a mask substrate which is translucent to the X-ray beam and the light beam;

an electrically conductive layer which is on said mask substrate, being translucent to the X-ray beam and the light beam;

stencil means which is partially formed on said electrically conductive layer to form patterns for forming the semiconductor chip patterns on the wafer by passing the X-ray beam through said stencil means, said stencil means being also translucent to the light beam for executing the alignment of the mask to the wafer;

a metal layer formed on said electrically conductive layer for forming a plating base by combining with said electrically conductive layer, said metal layer being translucent to the X-ray beam and the light beam; and

X-ray absorption means formed on said metal layer filling up an aperture of said patterns of said stencil means for forming the semiconductor chip patterns on the wafer by absorbing the X-ray beam.

An embodiment of the present invention provides a method for fabricating an X-ray exposure mask using for patterning a semiconductor wafer with semiconductor chip patterns by using an X-ray beam, a position of the mask relative to the wafer being aligned in a process of the patterning by using a light beam, said method comprising the steps of

(1) providing a mask substrate being translucent to the X-ray beam and the light beam;

(2) forming an electrically conductive layer being translucent to the X-ray beam and the light beam, on said mask substrate;

(3) forming a polymer layer on said electrically conductive layer;

(4) forming an inorganic layer on said polymer layer;

(5) forming a resist on said inorganic layer;

(6) writing mask patterns, which are to form the semiconductor chip patterns on the wafer, onto said resist, and developing said resist to form a stencil having patterns for forming the semiconductor chip patterns on the wafer;

(7) etching said inorganic layer;

(8) etching said polymer layer;

(9) forming gold having a thickness so as to be translucent to the X-ray beam and the light beam, for forming a plating base in combination with said electrically conductive layer; and

(10) plating gold on said plating base so as to fill up an aperture of said patterns of said stencil using said plating base as an electrode for the plating.

**Claims**

1. An X-ray exposure mask, comprising:-
   a mask substrate (1) translucent to X-ray and light beams;

an electrically conductive layer (9) on the mask substrate, translucent to X-ray and light beams; and

X-ray absorption means (7); characterised by

a stencil pattern structure (101, 111) formed on the electrically conductive layer (9), translucent to light;

a metal layer (12) formed on the electrically conductive layer, for forming a plating base with the electrically conductive layer (9), the metal layer (12) being translucent to X-ray and light beams; and by

the X-ray absorption means (7) being formed on the metal layer (12) in the stencil apertures of the stencil pattern structure (101, 111).

2. A mask as claimed in claim 1, wherein the electrically conductive layer (9) comprises indium tin oxide, comprising indium oxide and tin oxide.

3. A mask as claimed in claim 1 or 2, wherein the stencil pattern structure (101, 111) comprises material of polymer (101).

4. A mask as claimed in any preceding claim, wherein the metal layer (12) comprises material of gold.

5. A mask as claimed in any preceding claim, wherein the X-ray absorption means (7) comprises material of gold.

6. A method for fabricating a patterned X-ray exposure mask according to claim 1, comprising the steps of:-
   (1) providing a mask substrate (1) translucent to X-ray and light beams;
   (2) forming an electrically conductive layer (9), translucent to X-ray and light beams, on the mask substrate (1);
   (3) forming a polymer layer (10) on the electrically conductive layer (9);
   (4) forming an inorganic layer (11) on the polymer layer (10);
   (5) forming resist (5) on the inorganic layer (11);
   (6) writing mask patterns onto the resist, and developing the resist;
   (7) etching the inorganic layer (11) using the resist pattern (51) as a mask;
   (8) etching the polymer layer (10) using the patterned resist (51) and/or remaining inorganic layer (10) parts as a mask, the remaining inorganic layer and polymer layer parts providing a stencil pattern structure;

(9) forming gold (12), having a thickness such as to be translucent to X-ray and light beams, for forming a plating base in combination with the electrically conductive layer (9); and

(10) plating gold (7) on the plating base, so as to fill up at least partially apertures in the stencil pattern structure, using said plating base (12, 9) as an electrode for the plating.

## Patentansprüche

1. Röntgenstrahl-Belichtungsmaske, mit:

    einem Maskensubstrat (1), welches für Röntgen- und Lichtstrahlen durchlässig ist;

    einer elektrisch leitfähigen Schicht (9) auf dem Maskensubstrat, welche für Röntgen- und Lichtstrahlen durchlässig ist; und

    einem Röntgenstrahlabsorptionsmittel (7); gekennzeichnet durch

    eine lichtdurchlässige Schablonenmusterstruktur (101, 111), welche auf der elektrisch leitfähigen Schicht (9) gebildet ist;

    eine Metallschicht (12), die auf der elektrisch leitfähigen Schicht gebildet ist, zur Bildung einer Plattierungsbasis mit der elektrisch leitfähigen Schicht (9), wobei die Metallschicht (12) für Röntgen- und Lichtstrahlen durchlässig ist, und durch

    das Röntgenstrahlabsorptionsmittel (7), das auf der Metallschicht (12) in den Schablonenöffnungen der Schablonenmusterstruktur (101, 111) gebildet ist.

2. Maske nach Anspruch 1, bei welcher die elektrisch leitfähige Schicht (9) Indiumzinnoxid umfaßt, das Indiumoxid und Zinnoxid enthält.

3. Maske nach Anspruch 1 oder 2, bei welcher die Schablonenmusterstruktur (101, 111) Material von Polymer (101) umfaßt.

4. Maske nach einem der vorhergehenden Ansprüche, bei welcher die Metallschicht (12) Goldmaterial umfaßt.

5. Maske nach einem der vorhergehenden Ansprüche, bei welcher das Röntgenabsorptionsmittel (7) Goldmaterial umfaßt.

6. Verfahren zur Herstellung einer gemusterten Röntgenstrahl-Belichtungsmaske nach Anspruch 1, welches die Schritte umfaßt:

    (1) Vorsehen eines Maskensubstrats (1), welches für Röntgen- und Lichtstrahlen durchlässig ist;

    (2) Bilden einer elektrisch leitfähigen Schicht (9), die für Röntgen- und Lichtstrahlen durchlässig ist, auf dem Maskensubstrat (1);

(3) Bilden einer Polymerschicht (10) auf der elektrisch leitfähigen Schicht (9);

(4) Bilden einer anorganischen Schicht (11) auf der Polymerschicht (10);

(5) Bilden eines Resists (5) auf der anorganischen Schicht (11);

(6) Schreiben von Maskenmustern auf das Resist und Entwickeln des Resists;

(7) Ätzen der anorganischen Schicht (11) unter Verwendung des Resistmusters (51) als Maske;

(8) Ätzen der Polymerschicht (10) unter Verwendung des gemusterten Resists (51) und/oder verbleibender Teile der anorganischen Schicht (10) als Maske, wobei die verbleibenden Teile der anorganischen Schicht und der Polymerschicht eine Schablonenmusterstruktur vorsehen;

(9) Bilden von Gold (12) mit einer derartigen Dicke, um für Röntgen- und Lichtstrahlen durchlässig zu sein, zur Bildung einer Plattierungsbasis in Kombination mit der elektrisch leitfähigen Schicht (9); und

(10) Plattieren von Gold (7) auf der Plattierungsbasis, um Öffnungen in der Schablonenmusterstruktur zumindest teilweise auszufüllen, wobei die genannte Plattierungsbasis (12, 9) als Elektrode für das Plattieren verwendet wird.

## Revendications

1. Masque d'exposition radiographique, comprenant :

    un substrat (1) de masque qui est translucide aux faisceaux de rayons X et lumineux,

    une couche (9) conductrice de l'électricité formée sur le substrat du masque et translucide aux faisceaux de rayons X et lumineux, et

    un dispositif (7) d'absorption des rayons X, caractérisé par

    une structure (101, 111) de motifs d'écran formée sur la couche (9) conductrice de l'électricité et translucide à la lumière,

    une couche métallique (12) formée sur la couche conductrice de l'électricité et destinée à former une base de dépôt avec la couche (9) conductrice de l'électricité, la couche métallique (12) étant translucide aux faisceaux de rayons X et lumineux, et

    le dispositif (7) d'absorption des rayons X est formé sur la couche métallique (12) dans les ouvertures d'écran de la structure de motifs de l'écran (101, 111).

2. Masque selon la revendication 1, dans lequel la couche (9) conductrice de l'électricité contient de l'oxyde d'étain et d'indium contenant de l'oxyde d'indium et de l'oxyde d'étain.

3. Masque selon la revendication 1 ou 2, dans lequel la structure de motifs d'écran (101, 111) comprend un matériau polymère (101).

4. Masque selon l'une quelconque des revendications précédentes, dans lequel la couche métallique (12) est à base d'or.

5. Masque selon l'une quelconque des revendications précédentes, dans lequel le dispositif (7) d'absorption des rayons X est à base d'or.

6. Procédé de fabrication d'un masque d'exposition radiographique suivant des motifs selon la revendication 1, caractérisé en ce qu'il comprend les étapes suivantes :

    (1) la disposition d'un substrat (1) de masque qui est translucide aux faisceaux de rayons X et lumineux,

    (2) la formation d'une couche (9) conductrice de l'électricité, translucide aux faisceaux de rayons X et lumineux, sur le substrat (1) du masque,

    (3) la formation d'une couche polymère (10) sur la couche (9) conductrice de l'électricité,

    (4) la formation d'une couche minérale (11) sur la couche polymère (10),

    (5) la formation d'un matériau de réserve (5) sur la couche minérale (11),

    (6) l'écriture de motifs de masque sur le matériau de réserve et le développement du matériau de réserve,

    (7) l'attaque de la couche minérale (11) à l'aide du motif de matériau de réserve (51) comme masque,

    (8) l'attaque de la couche polymère (11) avec utilisation du matériau de réserve (51) formant un motif et/ou de parties restantes de la couche minérale (10) comme masque, les parties restantes de couche minérale et de couche polymère formant une structure de motifs d'écran,

    (9) la formation d'or (12), avec une épaisseur telle qu'il est translucide aux faisceaux de rayons X et lumineux, pour la formation d'une base de dépôt en combinaison avec la couche (9) conductrice de l'électricité, et

    (10) le dépôt d'or (7) sur la base de dépôt afin que les ouvertures de la structure de motifs d'écran soient remplies au moins partiellement, par utilisation de la base de dépôt (12, 9) comme électrode pour le dépôt.

# FIG. 1

# FIG. 2

FIG.3(a)

FIG.3(b)

FIG.3(c)

FIG.3(d)

FIG.3(e)

FIG.3(f)

FIG.4 (a)

FIG.4 (b)

FIG.4 (c)

FIG.4 (d)

FIG.4 (e)

FIG. 4 (f)

FIG.4 (g)

FIG.4 (h)